Europäisches Patentamt

European Patent Office

Office européen des brevets

(19)

(11) **EP 0 869 607 B1**

(12) **FASCICULE DE BREVET EUROPEEN**

(45) Date de publication et mention
de la délivrance du brevet:
**29.10.2003 Bulletin 2003/44**

(51) Int Cl.[7]: **H03F 3/343**, H03F 3/19

(21) Numéro de dépôt: **98400798.9**

(22) Date de dépôt: **03.04.1998**

(54) **Amplificateur avec etagé d'entrée en base commune**

Verstärker mit Eingangsstufe in Basisschaltung

Amplifier with common base input stage

(84) Etats contractants désignés:
**AT BE DE FR GB IT NL**

(30) Priorité: **04.04.1997 FR 9704155**

(43) Date de publication de la demande:
**07.10.1998 Bulletin 1998/41**

(73) Titulaire: **Atmel Grenoble**
**38120 Saint-Egrève (FR)**

(72) Inventeur: **Debroux, Jean-François**
**94117 Arcueil Cedex (FR)**

(74) Mandataire: **Guérin, Michel et al**
**THALES Intellectual Property,**
**31-33 Avenue Aristide Briand**
**94117 Arcueil Cédex (FR)**

(56) Documents cités:
**EP-A- 0 765 028**      **GB-A- 1 383 598**
**US-A- 5 285 143**

- **WHITE D J: "ANALOGUE FRONT END ELECTRONICS FOR THE ZEUS CENTRAL TRACKING DETECTOR" NUCLEAR SCIENCE SYMPOSIUM CONFERENCE RECORD, ARLINGTON, OCT. 22 - 27, 1990, vol. 1 OF 2, 22 octobre 1990, SMITH G C, pages 580-583, XP000232353**

## Description

L'invention se rapporte à un étage amplificateur de signaux en haute fréquence (HF) ou en fréquence intermédiaire (FI).

La réalisation de chaînes d'amplification fonctionnant en HF ou en FI fait en général appel à des amplificateurs dont l'impédance d'entrée est assez faible et bien définie car il est nécessaire qu'il y ait adaptation de l'impédance d'entrée de l'amplificateur à l'impédance de sortie d'un générateur connecté à l'entrée de cet l'amplificateur.

D'autre part pour les étages d'entrée de l'amplificateur (appelés aussi étages de tête) un facteur de bruit faible et un point de compression élevé sont recherchés pour obtenir les meilleures performances d'amplification. En effet, la dynamique du signal appliqué à l'étage d'entrée de l'amplificateur est limitée, dans les domaines de faibles signaux d'entrée, par le bruit propre de l'étage et dans le domaine de forts niveaux, par ses non linéarités.

En technologie bipolaire, la structure la mieux adaptée à ce type d'application est un étage d'entrée en base commune. Dans cette structure l'étage d'entrée comporte un transistor monté en base commune. Le signal d'entrée est appliqué à l'émetteur du transistor, la base étant polarisée par un potentiel fixe et l'émetteur étant polarisé par un courant constant. Le signal de sortie est prélevé en tension sur le collecteur du transistor grâce à une résistance de charge.

L'étage d'entrée en base commune possède naturellement une impédance d'entrée faible, un facteur de bruit faible et une bande passante élevée. Le point faible de ce type d'étage est sa linéarité médiocre. Malgré cet inconvénient c'est le montage en base commune qui présente la meilleure dynamique utile.

Il est connu que l'impédance d'entrée Zin, de l'étage en base commune, en petit signal s'établit à :

$$Zin = \frac{k.T}{q} \cdot \frac{1}{I_{co}}$$

Où k est la constante de Boltzmann (1.38 E-23 SI), q est la charge de l'électron (1.6 E-19 SI), T est la température absolue du transistor et $I_{co}$ le courant de collecteur au repos.

Le gain est tension Av en petit signal est :

$$Av = \frac{V_{S1}}{V_{E1}} = \frac{R_c.I_{co}}{\dfrac{k.T}{q}}$$

$V_{E1}$ étant la tension d'entrée de l'étage.
$V_{S1}$ étant la tension de sortie de l'étage.

$R_c$ est la valeur de la résistance de charge connectée entre le collecteur du transistor et une tension d'alimentation VCC.

Expression de la tension de sortie en fonction de la tension d'entrée, en grand signal :

$$V_{S1} = VCC - R_c \cdot \left( I_{co} \cdot \exp\left( -\frac{V_{in}}{\dfrac{k.T}{q}} \right) \right)$$

$V_{in}$ étant la tension d'entrée en grand signal.

La tension de sortie varie exponentiellement avec la tension d'entrée. Ceci montre bien la linéarité médiocre de cet étage. La zone « linéaire » en entrée est de quelques kT/q, soit quelques dizaines de millivolts au plus. De plus, la caractéristique de transfert non linéaire est génératrice d'harmoniques et d'intermodulation en sortie.

Deux solutions connues permettent d'améliorer la linéarité de l'étage base commune.

La première solution connue sous le nom de « dégénération » consiste à ajouter une résistance en série (résistance de dégénération) entre l'entrée de l'étage d'amplificateur et l'émetteur de transistor monté en base commune.

L'impédance d'entrée est augmentée de la valeur de cette résistance, ce qui conduit à augmenter le courant de repos du transistor, vu que l'impédance d'entrée de l'émetteur varie comme l'inverse du courant de repos.

La zone linéaire en entrée d'un tel étage est de l'ordre du produit du courant par la résistance de dégénération plus quelques kT/q. Elle est donc supérieure à celle de l'étage non dégénéré.

En contrepartie, le facteur de bruit est dégradé. L'augmentation des niveaux admissibles est plus faible que la dégradation du bruit. La dynamique utile est donc dégradée. Cette solution est cependant utilisée lorsqu'on souhaite augmenter les niveaux admissibles et lorsque le niveau de bruit n'est pas critique.

La seconde solution consiste à monter deux transistors sous forme différentielle, chacun des transistors étant monté en base commune. Dans cette configuration les émetteurs des transistors sont attaqués par un signal d'entrée sous forme différentielle, la sortie de l'étage s'effectuant de la même façon sous forme différentielle sur les collecteurs des deux transistors.

La réalisation de l'étage d'entrée sous forme différentielle permet de doubler l'impédance d'entrée de l'amplificateur. On peut doubler le courant de repos de chaque transistor si l'on souhaite conserver la même impédance d'entrée.

La zone linéaire en entrée est plus que doublée par rapport à l'étage simple, comportant un seul transistor, grâce à la compensation de courbure d'un transistor par l'autre.

Le facteur de bruit est légèrement dégradé par rapport à l'étage référencé. L'accroissement du niveau admissible est plus élevé que la dégradation du bruit La dynamique utile est donc un peu améliorée. La caractéristique de transfert est impaire, ce qui fait que le spectre de sortie contient peu d'harmoniques 2 et que le niveau d'intermodulation est plus faible.

Cet étage sous forme différentielle, comme l'étage dégénéré est intéressant pour augmenter le niveau admissible, lorsque les performances en bruit ne sont pas trop critiques. L'inconvénient de cet étage est de nécessiter un signal sous forme différentielle, ce qui est rarement le cas dans les systèmes HF, où le signal est souvent référencé à la masse.

De la même façon que dans le cas d'un étage comportant un seul transistor monté en base commune, l'étage différentiel peut être dégénéré par la mise en série d'une résistance entre chaque entrée différentielle de l'étage et chaque émetteur des deux transistors. Cela permet d'étendre la plage de linéarité d'entrée mais au détriment du facteur de bruit. Dans cette configuration le niveau admissible du signal d'entrée est accru mais la dynamique utile s'en trouve réduite.

Afin de pallier aux inconvénients de l'art antérieur l'invention propose un étage amplificateur dont la structure générale est la suivante : l'entrée est non différentielle mais référencée par rapport à un potentiel de référence (masse par exemple) ; l'entrée est de type base commune, c'est-à-dire qu'elle se fait sur l'émetteur d'un transistor d'entrée ; ce premier transistor convertit en variations de courant, avec une courbe de transfert non linéaire, en principe exponentielle pour les transistors bipolaires et quadratique pour les transistors à effet de champ, les variations de tension d'entrée ; ces variations de courant sont elles-mêmes recopiées avec changement de signe, dans une branche comportant un deuxième et un troisième transistors, puis elles sont converties en variations de tension, avec une courbe de transfert non linéaire, réciproque de la précédente, en principe logarithmique ou en racine carrée, par le troisième transistor, et la tension aux bornes du troisième transistor est utilisée comme contre-réaction appliquée à la base du premier transistor.

La recopie de courant (avec ou non la même amplitude) se fait de préférence en faisant parcourir le premier transistor par un courant imposé i, et en établissant une tension d'alimentation $[V_{be2} + V_{be3} + (R1 + k.R2).i]$ aux bornes d'un ensemble en série d'une résistance de valeur R1 parcourue par le courant i, d'une jonction émetteur-base du deuxième transistor, d'une résistance de valeur R2, et du troisième transistor monté en diode, $V_{be2}$ et $V_{be3}$ étant les chutes de tension aux bornes des jonctions base-émetteur des deuxième et troisième transistors supposés parcourus par un courant k.i, k étant un rapport de courants désiré.

En effet, l'application d'une telle tension d'alimentation à cet ensemble en série impose le passage d'un courant k.i dans la deuxième résistance, et toute variation du courant i dans la première résistance de valeur R1 se répercute avec un signe opposé (avec une amplitude égale ou proportionnelle) dans la deuxième résistance de valeur R2.

D'autres caractéristiques et avantages de l'invention ainsi que celles de certaines de ses variantes, apparaîtront à la lecture de la description détaillée et qui est faite en référence aux dessins annexés dans lesquels :

- la figure 1 représente un étage d'amplificateur selon l'invention comportant une sortie référencée ;
- la figure 2 représente une première variante de l'étage d'amplification comportant une sortie différentielle ;
- la figure 3 représente une deuxième variante de l'étage d'amplification cascodé ;
- la figure 4 représente une troisième variante de l'étage d'amplification comportant un mélangeur de GILBERT.

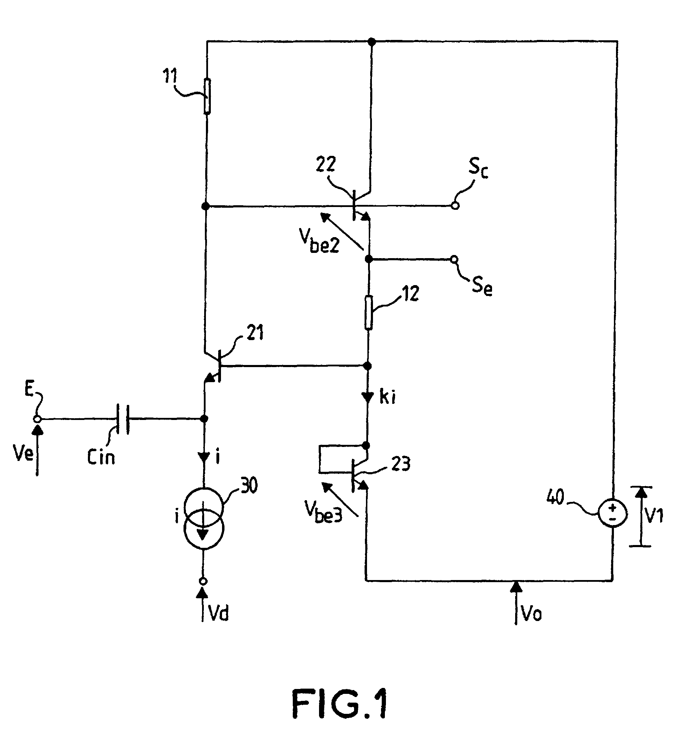

La figure 1 représente un étage d'amplificateur selon l'invention comprenant deux branches dont la première comporte au moins une première résistance 11 de valeur R1 en série avec un premier transistor 21 et une source de courant 30 de valeur i, et dont la deuxième comporte au moins un deuxième transistor 22 en série avec une deuxième résistance 12 de valeur R2 et avec un troisième transistor 23, l'émetteur du troisième transistor 23 étant relié à un potentiel de référence Vo, l'entrée E de l'amplificateur étant reliée à l'émetteur du premier transistor 21 (par une capacité Cin par exemple), des moyens 40 pour appliquer aux deux branches un potentiel identique V1 dont la valeur prise par rapport au potentiel de référence Vo, est égale à $[V_{be2} + V_{be3} + (R1 + k.R2).i]$, $V_{be2}$ et $V_{be3}$ étant respectivement les chutes de tension entre base et émetteur des deuxième et troisième transistors lorsqu'ils sont parcourus par un courant k.i, et k étant un rapport quelconque désiré entre le courant parcourant la deuxième branche et le courant parcourant la première, la base du deuxième transistor 22 étant reliée au collecteur du premier transistor 21, et la base du premier transistor 21 étant reliée à la base et au collecteur du troisième transistor 23.

Dans le cas où le deuxième transistor 22 et le troisième transistor 23 sont identiques, le potentiel identique V1 appliqué aux deux branches est égal à $[2 V_{be3} + (R1 + k.R2).i]$.

Si nous considérons en plus que les résistances 11 et 12 sont de même valeur R1, le potentiel identique appliqué aux deux branches est $[2 V_{be3} + (1+k) R1.i]$.

Dans le cas où tout en ayant un deuxième et troisième transistors identiques et des courants identiques dans les deux branches (k=1), le potentiel identique V1 appliqué est égal à $[2 V_{be3} + (R1 + R2).i]$.

Considérons le cas particulier où les résistances 11 et 12 ont la même valeur R1 et k=1, le potentiel identique V1 appliqué aux deux branches sera égal à 2 $[V_{be3} + R1 .i]$.

Dans ce dernier cas particulier, le courant dans le premier transistor 21 étant i au repos, la somme des courants de collecteurs du premier et troisième transistors (21 et 23) est constante. En effet, au repos la tension sur le collecteur du premier transistor 21 est égale à V1-R1.i.

La tension sur l'émetteur du deuxième transistor 22 est égale à $V1-R1.i-V_{be3}$. La tension aux bornes de la deuxième résistance 12 est égale à $V1-2V_{be3}-R1.i$ comme V1 a une valeur égale à $2.(V_{be3}+R1.i)$, la tension aux bornes de la deuxième résistance 12 vaut R1.i. Donc le courant dans la deuxième résistance 12 et par conséquent dans le troisième transistor 23 s'établit à i.

En présence d'un petit signal d'entrée Ve à l'entrée E de l'amplificateur, si le courant de collecteur du premier transistor 21 s'accroît d'une valeur $\Delta i$, la tension sur le collecteur du premier transistor 21 décroît de la valeur R1. $\Delta i$ donc la tension aux bornes de la deuxième résistance 12 décroît de la même quantité. Le courant dans le troisième transistor 23 décroît donc de la valeur $\Delta i$. La somme des courants de collecteurs du premier et du troisième transistors 21 et 23 est donc constante. L'accroissement de la tension à l'éntrée E, cause de l'accroissement $\Delta i$ du courant de collecteur i du premier transistor 21, se traduit donc par une diminution de la tension base émetteur $V_{be3}$ du troisième transistor 23 de la même quantité.

La tension sur la base du premier et du troisième transistors varie donc comme la moitié du signal d'entrée Ve, en première approximation, dans le cas où les transistors 21 et 23 sont identiques.

L'accroissement du courant $\Delta i$ s'établit donc à : $\Delta i = (gm1)/2$

Le gain en tension Av s'établit donc à : Av = (gm1.R1)/2 gm1 étant la transconductance du premier transistor 21.

L'impédance d'entrée Zin de l'amplificateur s'établit donc à Zin = 2 .(KT/q) . (1/i).

Lorsque le signal d'entrée Ve est de niveau important, la somme des courants de collecteur dans les transistors 21 et 23 étant constante, des limitations symétriques de signal existent lorsque le courant dans le collecteur d'un des transistors 21 ou 23 est égal à 2.i.

Entre ces deux extrêmes, un calcul complet montre que le signal de sortie varie en fonction du signal d'entrée selon une loi proche de la loi en tangente hyperbolique des amplificateurs différentiels.

Dans le domaine fréquentiel, un calcul complet montre des effets de compensation qui assurent un fonctionnement de la boucle de contre-réaction sans risque d'oscillations.

La caractéristique de transfert est impaire, ce qui garantit un niveau faible d'harmoniques paires. Cette caractéristique est linéaire sur une plage assez large ce qui garantit un faible niveau d'intermodulation.

Le signal en sortie de l'amplificateur peut être prélevé soit sur une première sortie $S_e$ connectée à un point de jonction entre la deuxième résistance 12 et l'émetteur du deuxième transistor 22, soit sur une seconde sortie $S_c$ à un point de jonction entre le collecteur du premier transistor et une extrémité de la première résistance 11.

Si le signal de sortie est prélevé sur l'émetteur du deuxième transistor 22, l'impédance de sortie est beaucoup plus faible que si le signal est prélevé sur le collecteur du premier transistor 21 et la charge influe peu sur la bande passante.

Les moyens 40 pour appliquer un potentiel identique V1 aux deux branches et la source de courant 30 imposant le courant i peuvent être réalisés par différents moyens connus. Dans un circuit monolithique, on peut mettre à profit le bon appariement des composants et le fait que tous soient à la même température, pour créer le potentiel V1 à l'aide d'un asservissement. Le résultat est un peu plus complexe qu'une simple source de courant, mais ne concerne que des tensions et des courants continus et non le signal haute fréquence.

Performances de l'amplificateur selon l'invention :

L'étage de la figure 1 ayant été dimensionné de façon à présenter une impédance d'entrée de 50 ohms et un gain de 25 dB, on obtient un facteur de bruit de l'ordre de 6 décibels et une valeur de niveau du signal d'entrée pour obtenir un point de compression à 1 décibel, comparable à celui de l'étage classique en base commune.

Le niveau d'intermodulation d'ordre 3 en sortie de l'étage est 36 dB plus faible que pour l'étage classique. le niveau d'entrée pour produire le même niveau d'intermodulation est 12 dB plus important que pour l'étage classique.

Dans tous les cas, et surtout avec de grands signaux à l'entrée, le spectre du signal de sortie du nouvel étage linéarisé comporte beaucoup moins d'harmonique. Le niveau d'harmonique 2 est 30 dB plus bas avec le nouvel étage et le niveau des autres harmoniques, notamment l'harmonique 3 est très faible.

Le nouvel étage présente donc une amélioration significative de performances par rapport à l'art antérieur.

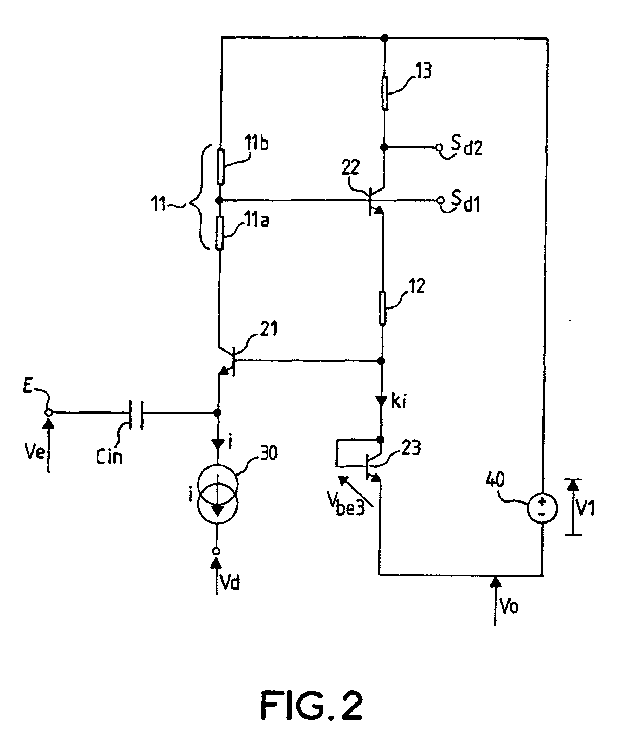

La figure 2 montre une première variante de l'étage de base de la figure 1.

Les courants de collecteur du premier transistor 21 et du deuxième transistor 22 sont en opposition de phase. Cette particularité peut être mise à profit pour récupérer le signal sous forme différentielle. Pour cette nouvelle configuration la deuxième branche comporte une troisième résistance 13, de valeur n.R1, n étant inférieur à 1, dont une extrémité est connectée au collecteur du deuxième transistor 22, et l'autre reçoit le potentiel V1 égal à $[2V_{be3} + (R1 + k.R2).i]$, et la première résistance 11 de valeur R1 est constituée de la somme d'une résistance 11a de valeur (1-n).R1 reliée au collecteur du premier transistor 21, en série avec une résistance 11b de valeur n.R1, l'amplificateur comportant deux sorties différentielles, l'une $S_{d1}$ connectée au point de jonction de ces deux dernières résistances, et l'autre $S_{d2}$ connectée au collecteur du deuxième transistor 22.

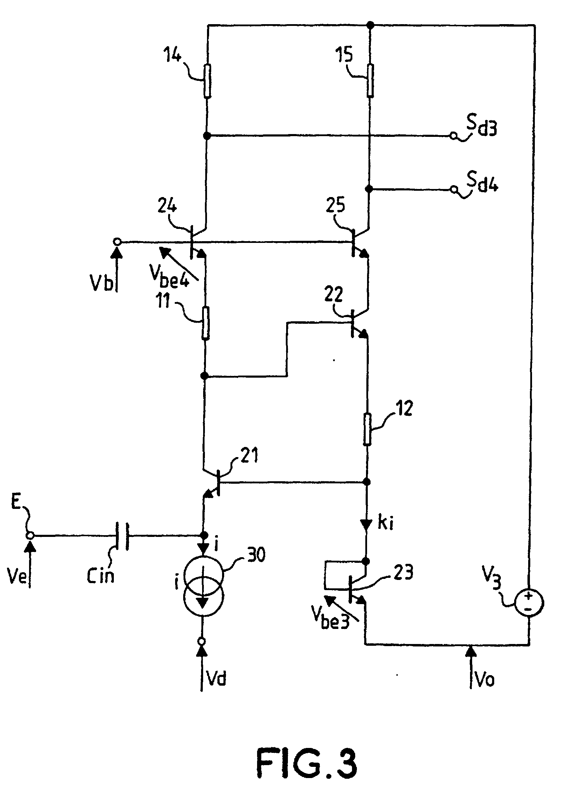

La figure 3 montre l'étage de la figure 1 cascodé afin de diminuer les capacités d'entrée et de sortie de l'amplificateur. Dans cette variante, le potentiel $[2V_{be3} + (R1 + k.R2).i]$ est appliqué aux deux branches par les émetteurs d'un quatrième transistor 24 et d'un cinquième transistor 25, dont les bases sont reliées à un potentiel de base $V_b$ égal à $[V_{be4} + 2V_{be3} + (R1 + k.R2).i]$, $V_{be4}$ étant la chute de tension base-émetteur du quatrième transistor 24 lorsqu'il est parcouru par le courant i, l'amplificateur comportant encore :

- une quatrième résistance 14 connectée entre le collecteur du quatrième transistor et une source de tension V3,
- une cinquième résistance 15 connectée entre le collecteur du cinquième transistor 25 et la source de tension V3,
- et deux sorties différentielles Sd3 et $S_{d4}$ connectées respectivement aux collecteurs des quatrième et du cinquième transistors.

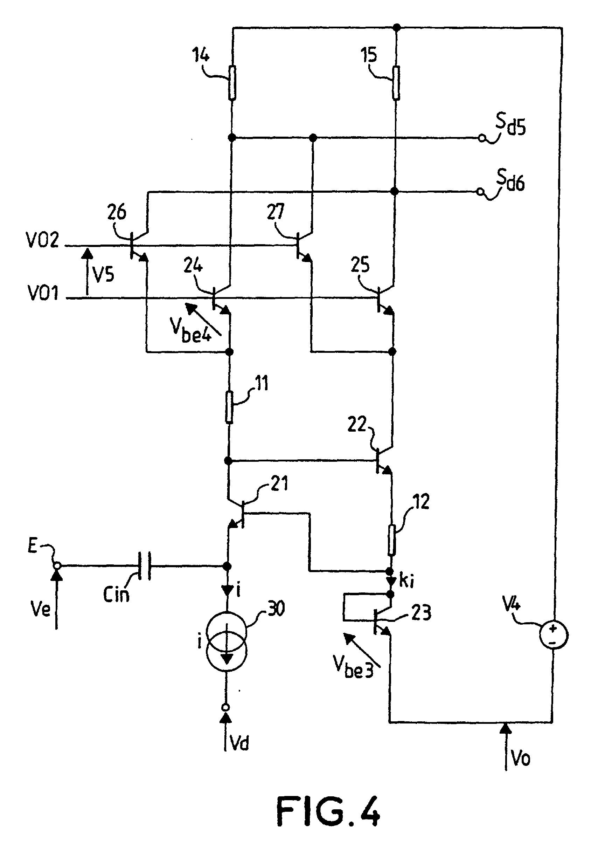

Il est également possible d'attaquer un mélangeur de GILBERT par les deux sorties en courant des deux branches sans passer par une conversion courant tension, ce qui permet une réduction significative de bruit. La figure 4 montre un schéma comportant un étage d'entrée mélangeur de GILBERT à faible consommation. Dans cette configuration, le potentiel $[2V_{be3} + (R1 + k.R2).i]$ est appliqué aux deux branches par les émetteurs d'un quatrième transistor 24 et d'un cinquième transistor 25 dont les bases sont reliées, l'amplificateur comportant encore :

- une quatrième résistance 14 connectée entre le collecteur du quatrième transistor 24 et une source de tension V4,
- une cinquième résistance 15 connectée entre le collecteur du cinquième transistor 25 et la source de tension V4,
- un sixième transistor 26 dont l'émetteur est relié à l'émetteur du quatrième transistor 24 et le collecteur est relié au collecteur du cinquième transistor 25,
- un septième transistor 27 dont l'émetteur est relié à l'émetteur du cinquième transistor 25 et le collecteur est relié au collecteur du quatrième transistor 24, les bases des sixième et septième transistors étant reliées,

Des sorties différentielles $S_{d5}$ et $S_{d6}$ connectées respectivement aux collecteurs des quatrième et cinquième transistors, la base du quatrième transistor et la base du sixième transistor recevant des tensions différentielles alternatives V01 et V02 ayant un potentiel de mode commun V5 fixe égal à $[V_{be4} + 2V_{be3} + (R1 +$ k.R2).i]$, $V_{be4}$ étant la chute de tension base-émetteur du quatrième transistor 24 lorsqu'il est parcouru par le courant i.

Dans tous les cas des schémas décrits précédemment la source de courant 30 placée à une extrémité de la première branche, sera connectée à un potentiel $V_d$ inférieur au potentiel de référence Vo appliqué à l'autre extrémité de la première branche.

Les transistors utilisés dans les schémas qui précèdent sont des transistors NPN. Des schémas identiques seraient utilisables avec des transistors PNP en inversant les polarités des alimentations.

Les schémas qui ont été décrits précédemment utilisent des transistors bipolaires. Ces schémas sont cependant transposables en technologie MOS, tous les transistors de circuits pouvant être remplacés par des transistors à effet de champ. La base, l'émetteur et le collecteur des transistors doivent alors être interprétés comme pouvant signifier soit la base, l'émetteur et le collecteur si les transistors sont bipolaires soit la grille, la source et le drain respectivement si les transistors sont des transistors à effet de champ.

Le fonctionnement est pratiquement identique, à l'exception du fait que la conversion tension-courant, qui est de type exponentiel pour un transistor bipolaire, devient de type quadratique pour un transistor à effet de champ.

## Revendications

**1.** Amplificateur à entrée non différentielle, comprenant deux branches dont la première comporte au moins une première résistance (11) de valeur R1 en série avec un premier transistor (21) et une source de courant (30) de valeur i, et dont la deuxième comporte au moins un deuxième transistor (22) en série avec une deuxième résistance (12) de valeur R2 et avec un troisième transistor (23), l'émetteur du troisième transistor (23) étant relié à un potentiel de référence Vo, l'entrée (E) de l'amplificateur étant reliée à l'émetteur du premier transistor (21), des moyens (40) pour appliquer aux deux branches un potentiel identique V1 dont la valeur prise par rapport au potentiel de référence Vo, est égale à $V_{be2}$ + $V_{be3}$ + (R1 + k * R2) * i, $V_{be2}$ et $V_{be3}$ étant respectivement les chutes de tension entre base et émetteur des deuxième et troisième transistors lorsqu'ils sont parcourus par un courant k.i, et k étant un rapport quelconque désiré entre le courant parcourant la deuxième branche et le courant parcourant la première, la base du deuxième transistor (22) étant reliée au collecteur du premier transistor (21), et la base du premier transistor (21) étant reliée à la base et au collecteur du troisième transistor (23).

**2.** Amplificateur selon la revendication 1, **caractérisé en ce que** les deuxième et troisième transistors sont identiques et le potentiel identique V1 appliqué aux deux branches est égal à $2V_{be3}$ + (R1 + k * R2) * i.

3. Amplificateur selon l'une des revendications 1 et 2, **caractérisé en ce que** la première résistance (11) et la deuxième résistance (12) sont de même valeur R1 et le potentiel identique appliqué aux deux branches est $2V_{be3}$ + (1 + k) * R1 * i.

4. Amplificateur selon l'une des revendications 1 à 3, **caractérisé en ce que** le rapport k est égal à 1, les courants dans les deux branches étant identiques, et le potentiel identique appliqué est $2V_{be3}$ + (R1 + R2) * i.

5. Amplificateur selon l'une des revendications 1 à 4, **caractérisé en ce que** la source de courant (30), placée à une extrémité de la première branche, est connectée à un potentiel $V_d$ inférieur au potentiel de référence Vo appliqué à l'autre extrémité de la première branche.

6. Amplificateur selon l'une des revendications 1 à 5, **caractérisé en ce qu'**il possède une première sortie Se connectée à un point de jonction entre la deuxième résistance (12) et l'émetteur du deuxième transistor (22), le potentiel $2V_{be3}$ + (R1 + k * R2) * i étant appliqué au collecteur du deuxième transistor.

7. Amplificateur selon l'une des revendications 1 à 6, **caractérisé en ce qu'**il possède une seconde sortie $S_c$ connectée à un point de jonction entre le collecteur du premier transistor et une extrémité de la première résistance (11), le potentiel $2V_{be3}$ + (R1 + k * R2) * i étant appliqué à l'autre extrémité de la résistance.

8. Amplificateur selon l'une des revendications 1 à 5, **caractérisé en ce que** la deuxième branche comporte une troisième résistance (13), de valeur n.R1, n étant inférieur à 1, dont une extrémité est connectée au collecteur du deuxième transistor (22), et l'autre reçoit le potentiel V1 égal à $2V_{be3}$ + (R1 + k * R2) * i, et la première résistance (11) de valeur R1 est constituée de la somme d'une résistance (11a) de valeur (1-n).R1 reliée au collecteur du premier transistor (21), en série avec une résistance (11b) de valeur n.R1, l'amplificateur comportant deux sorties différentielles, l'une ($S_{d1}$) connectée au point de jonction de ces deux dernières résistances, et l'autre ($S_{d2}$) connectée au collecteur du deuxième transistor (22).

9. Amplificateur selon l'une des revendications 1 à 5, **caractérisé en ce que** le potentiel $2V_{be3}$ + (R1 + k * R2) * i est appliqué aux deux branches par les émetteurs d'un quatrième transistor (24) et d'un cinquième transistor (25), dont les bases sont reliées à un potentiel de base $V_b$ égal à $V_{be4}$ + $2V_{be3}$ + (R1 + k * R2) * i, $V_{be4}$ étant la chute de tension base-émetteur du quatrième transistor (24) lorsqu'il est parcouru par le courant i, l'amplificateur comportant encore :

- une quatrième résistance (14) connectée entre le collecteur du quatrième transistor (24) et une source de tension (V3),
- une cinquième résistance (15) connectée entre le collecteur du cinquième transistor (25) et la source de tension (V3),
- et deux sorties différentielles ($S_{d3}$) et ($S_{d4}$) connectées respectivement aux collecteurs des quatrième et cinquième transistors (24, 25).

10. Amplificateur selon l'une des revendications 1 à 5, **caractérisé en ce que** le potentiel $2V_{be3}$ + (R1 + k * R2) * i est appliqué aux deux branches par les émetteurs d'un quatrième transistor (24) et d'un cinquième transistor (25) dont les bases sont reliées, l'amplificateur comportant encore :

- une quatrième résistance (14) connectée entre le collecteur du quatrième transistor (24) et une source de tension (V4),
- une cinquième résistance (15) connectée entre le collecteur du cinquième transistor (25) et la source de tension (V4),
- un sixième transistor (26) dont l'émetteur est relié à l'émetteur du quatrième transistor (24) et le collecteur est relié au collecteur du cinquième transistor (25),
- un septième transistor (27) dont l'émetteur est relié à l'émetteur du cinquième transistor (25) et le collecteur est relié au collecteur du quatrième transistor (24), les bases des sixième et septième transistors étant reliées,
- des sorties différentielles ($S_{d5}$) et ($S_{d6}$) connectées respectivement aux collecteurs des quatrième et cinquième transistors, la base du quatrième transistor et la base du sixième transistor recevant des tensions différentielles alternatives V01 et V02 ayant un potentiel de mode commun V5 fixe égal à $V_{be4}$ + $2V_{be3}$ + (R1 + k * R2) * i, $V_{be4}$ étant la chute de tension base-émetteur du quatrième transistor (24) lorsqu'il est parcouru par le courant i.

11. Etage amplificateur comprenant une entrée non différentielle, référencée par rapport à un potentiel de référence, l'entrée étant de type base commune, c'est-à-dire qu'elle se fait sur l'émetteur d'un transistor d'entrée, ce premier transistor convertissant en variations de courant, avec une courbe de transfert non linéaire, en principe exponentielle pour les transistors bipolaires et quadratique pour les transistors à effet de champ, les variations de tension d'entrée, ces variations de courant étant elles-mêmes recopiées avec changement de signe dans une branche comportant un deuxième et un troisième transistors, puis converties en variations de tension, avec une courbe de transfert non linéaire, réciproque de la précédente, en principe logarithmique ou en racine carrée, par le troisième transistor, et la tension aux bornes du troisième transistor étant utiliseé comme contre-réaction appliquée à la base du premier transistor, la recopie de courant étant effectuée en faisant parcourir le premier transistor par un courant imposé i, et en établissant une tension d'alimentation $V_{be2} + V_{be3} + (R1 + k * R2) * i$ aux bornes d'un ensemble en série d'une résistance de valeur R1 parcourue par le courant i, d'une jonction émetteur-base du deuxième transistor, d'une résistance de valeur R2, et du troisième transistor monté en diode, $V_{be2}$ et $V_{be3}$ étant les chutes de tension aux bornes des jonctions base-émetteur des deuxième et troisième transistors supposés parcourus par un courant k * i, k étant un rapport de courants désiré.

**Patentansprüche**

1. Verstärker mit einem nicht-differentiellen Eingang und mit zwei Zweigen, von denen der erste mindestens einen ersten Widerstand (11) des Werts R1 in Reihe mit einem ersten Transistor (21) und einer Stromquelle (30) des Werts i aufweist, während er zweite Zweig mindestens einen zweiten Transistor (22) in Reihe mit einem zweiten Widerstand (12) des Werts R2 und einem dritten Transistor (23) enthält, wobei der Emitter des dritten Transistors (23) an ein Bezugspotential Vo angeschlossen ist und der Eingang (E) des Verstärkers mit dem Emitter des ersten Transistors (21) verbunden ist und wobei Mittel (40) vorgesehen sind, die an die beiden Zweige ein gleiches Potential V1 anlegen, das bezüglich des Bezugspotentials Vo den Wert $V_{be2}+V_{be3}+(R1+k.R2).i$ besitzt, wobei $V_{be2}$ und $V_{be3}$ die Spannungsabfälle zwischen Basis und Emitter des zweiten beziehungsweise dritten Transistors sind, wenn diese von einem Strom k.i durchflossen werden, und wobei k ein beliebiges gewünschtes Verhältnis zwischen dem den zweiten Zweig durchfließenden Strom und dem den ersten Zweig durchfließenden Strom ist, und die Basis des zweiten Transistors (22) mit dem Kollektor des ersten Transistors (21) und die Basis des ersten . Transistors (21) mit der Basis und mit dem Kollektor des dritten Transistors (23) verbunden ist.

2. Verstärker nach Anspruch 1, **dadurch gekennzeichnet, daß** der zweite und der dritte Transistor einander gleichen und daß das gemeinsame Potential V1, das an die beiden Zweige angelegt wird, den Wert $2.V_{be3}+(R1+k.R2).i$ hat.

3. Verstärker nach einem der Ansprüche 1 und 2, **dadurch gekennzeichnet, daß** der erste Widerstand (11) und der zweite Widerstand (12) den gleichen Wert R1 besitzen und daß das gemeinsame Potential, das an die beiden Zweige angelegt wird, den Wert $2.V_{be3}+(1+k).R1.i$ hat.

4. Verstärker nach einem der Ansprüche 1 bis 3, **dadurch gekennzeichnet, daß** das Verhältnis k den Wert 1 hat, daß die Ströme in den beiden Zweigen einander gleichen und daß das gemeinsame angelegte Potential den Wert $2.V_{be3}+ (R1+R2).i$ hat.

5. Verstärker nach einem der Ansprüche 1 bis 4, **dadurch gekennzeichnet, daß** die Stromquelle (30), die mit einem Ende des ersten Zweigs verbunden ist, an ein Potential $V_d$ angeschlossen ist, das unter dem wert des Bezugspotentials Vo liegt, welches an das andere Ende des ersten Zweigs angelegt ist.

6. Verstärker nach einem der Ansprüche 1 bis 5, **dadurch gekennzeichnet, daß** er einen ersten Ausgang $S_e$ besitzt, der an einen Verbindungspunkt zwischen dem zweiten Widerstand 12 und dem Emitter des zweiten Transistors (22) angeschlossen ist, wobei das Potential $2.V_{be3}+(R1+k.R2).i$ an den Kollektor des zweiten Transistors angelegt ist.

7. Verstärker nach einem der Ansprüche 1 bis 6, **dadurch gekennzeichnet, daß** er einen zweiten Ausgang $S_c$ besitzt, der an einen Verbindungspunkt zwischen dem Kollektor des ersten Transistors und einem Ende des ersten Widerstands (11) angeschlossen ist, wobei das Potential $2.V_{be3}+(R1+k.R2).i$ an das andere Ende dieses Widerstands angelegt wird.

8. Verstärker nach einem der Ansprüche 1 bis 5, **dadurch gekennzeichnet, daß** der zweite Zweig einen dritten Widerstand (13) mit dem Wert n.R1 besitzt, mit n<1, und ein Ende dieses Widerstands mit dem Kollektor des zweiten Transistors (22) verbunden ist, während das andere Ende das Potential V1 mit dem Wert $2.V_{be3}+(R1+k.R2).i$ empfängt, und daß der erste Widerstand (11) mit dem Wert R1 aus der Summe eines Widerstands (11a) des Werts (1-n).R1, der an den Kollektor des ersten Transistors (21) angeschlossen ist, und eines Widerstands (11b) des Werts n.R1 gebildet wird, und daß der Verstärker zwei Differential-Ausgänge besitzt, von denen der eine $(S_{d1})$ an den Verbindungspunkt zwischen diesen beiden letztgenannten Widerständen und der andere $(S_{d2})$ an den Kollektor des zweiten Transistors (22) angeschlossen ist.

**9.** Verstärker nach einem der Ansprüche 1 bis 5, **dadurch gekennzeichnet, daß** das Potential $2.V_{be3}+(R1+k.R2).i$ an die beiden Zweige über den Emitter eines vierten Transistors (24) beziehungsweise eines fünften Transistors (25) angelegt ist, deren Basiselektroden an ein Basispotential $V_b$ des Werts $V_{be4}+2.V_{be3}+(R1+k.R2).i$ angeschlossen sind, wobei $V_{be4}$ der Spannungsabfall zwischen Basis und Emitter des vierten Transistors (24) ist, wenn dieser vom Strom i durchflossen wird, und daß der Verstärker weiter aufweist:

- einen vierten Widerstand (14), der zwischen den Kollektor des vierten Transistors (24) und eine Spannungsquelle (V3) eingefügt ist,
- einen fünften Widerstand (15), der zwischen den Kollektor des fünften Transistors (25) und die Spannungsquelle (V3) eingefügt ist,
- und zwei Differential-Ausgänge ($S_{d3}$ und $S_{d4}$), die an den Kollektor des vierten beziehungsweise fünften Transistors (24, 25) angeschlossen sind.

**10.** Verstärker nach einem der Ansprüche 1 bis 5, **dadurch gekennzeichnet, daß** das Potential $2.V_{be3}+(R1+k.R2).i$ an die beiden Zweige über den Emitter eines vierten Transistors (24) und den Emitter eines fünften Transistors (25) angelegt wird, deren Basiselektroden miteinander verbunden sind, wobei der Verstärker weiter enthält:

- einen vierten Widerstand (14), der zwischen den Kollektor des vierten Transistors (24) und eine Spannungsquelle (V4) eingefügt ist,
- einen fünften Widerstand (15), der zwischen den Kollektor des fünften Transistors (25) und die Spannungsquelle (V4) eingefügt ist,
- einen sechsten Transistor (26), dessen Emitter an den Emitter des vierten Transistors (24) und dessen Kollektor an den Kollektor des fünften Transistors (25) angeschlossen ist,
- einen siebten Transistor (27), dessen Emitter an den Emitter des fünften Transistors (25) und dessen Kollektor an den Kollektor des vierten Transistors (24) angeschlossen ist, wobei die Basiselektroden des sechsten und des siebten Transistors miteinander verbunden sind,

und wobei Differentialausgänge ($S_{d5}$ und $S_{d6}$) an den Kollektor des vierten beziehungsweise des fünften Transistors angeschlossen sind und die Basis des vierten Transistors und die Basis des sechsten Transistors Differential-Wechselspannungen V01 und V02 mit einem festen Gleichtakt-Potential V5 des Werts $V_{be4}+2.V_{be3}+(R1+k.R2).i$ empfangen und $V_{be4}$ der Spannungsabfall zwischen der Basis und dem Emitter des vierten Transistors (24) ist, wenn er von einem Strom i durchflossen wird.

**11.** Verstärkerstufe mit einem nicht-differentiellen Eingang, der auf ein Bezugspotential bezogen ist, wobei der Eingang als Basisschaltung vorliegt, das heißt, daß das Eingangssignal an den Emitter eines Eingangstransistors gelangt, und dieser erste Transistor die Schwankungen der Eingangsspannungen in Stromschwankungen über eine nichtlineare Transferkennlinie, im Prinzip eine exponentielle Kennlinie für die bipolaren Transistoren und eine quadratische Kennlinie für die Feldeffekt-Transistoren umwandelt, worauf diese Stromschwankungen ihrerseits mit einem Vorzeichenwechsel in einen Zweig mit einem zweiten und einem dritten Transistor kopiert und dann vom dritten Transistor in Spannungsschwankungen mit einer nichtlinearen Transferkennlinie umgewandelt werden, die zur vorigen Kennlinie reziprok ist, im Prinzip logarithmisch beziehungsweise gemäß einer Quadratwurzel, und wobei die Spannung an den Elektroden des dritten Transistors als Gegenkopplung an die Basis des ersten Transistors zurückgeschleift wird, wobei die Kopie des Stroms sich ergibt, indem der erste Transistor durch einen Sollstrom i gespeist wird und indem an die Klemmen einer Serienschaltung aus einem Widerstand mit dem Wert R1, durch den der Strom i fließt, dem Emitter/Basisübergang des zweiten Transistors, einem Widerstand des Werts R2 und dem dritten als Diode geschalteten Transistor eine Speisespannung des Werts $V_{be2}+V_{be3}+(R1+k.R2).i$ angelegt wird, wobei $V_{be2}$ und $V_{eb3}$ die Spannungsabfälle zwischen den Basis/Emitteranschlüssen des zweiten und des dritten Transistors sind, die als von einem Strom k.i durchflossen angenommen werden, wobei k ein gewünschtes Stromverhältnis ist.

**Claims**

**1.** Amplifier with non-differential input comprising two arms, the first arm having at least one first resistor (11) with a value R1 series-connected with a first transistor (21) and a current source (30) with a value i, the second arm having at least one second transistor (22) series-connected with a second resistor (12) having a value R2 and with a third transistor (23), the emitter of this third transistor (23) being connected to a reference potential Vo, the input (E) of the amplifier being connected to the emitter of the first transistor (21), means (40) for the application, to the two arms, of an identical potential V1 whose value, taken with respect to the reference potential Vo, is equal to $[V_{be2} + V_{be3} + (R1 + k.R2).i]$, $V_{be2}$ and $V_{be3}$ being respectively the voltage drops between the base and the emitter of the second and third transistors when a current k.i flows through them, and k being any desired ratio between the current flowing through the second arm and the current flowing through the first arm, the base of the second transistor (22) being connected to the collector of the first transistor (21) and the base of the first transistor (21) being connected to the base and to the collector of the third transistor (23).

2. Amplifier according to Claim 1, **characterized in that** the second and third transistors are identical and the identical potential V1 applied to the two arms is equal to $[2V_{be3} + (R1 + k.R2).i]$.

3. Amplifier according to either of Claims 1 and 2, **characterized in that** the first resistor (11) and the second resistor (12) have the same value R1, and the identical potential applied to the two arms is $[2V_{be3} + (1 + k).R1.i]$.

4. Amplifier according to one of Claims 1 to 3, **characterized in that** the ratio k is equal to 1, the currents in the two arms being identical, and the identical potential applied is $[2V_{be3} + (R1 + R2).i]$.

5. Amplifier according to one of Claims 1 to 4, **characterized in that** the current source (30), placed at one end of the first arm, is connected to a potential $V_d$ smaller than the reference potential Vo applied to the other end of the first arm.

6. Amplifier according to one of Claims 1 to 5, **characterized in that** it possesses a first output $S_e$ connected to a point of junction between the second resistor (12) and the emitter of the second transistor (22), the potential $[2V_{be3} + (R1 + k.R2).i]$ being applied to the collector of the second transistor.

7. Amplifier according to one of Claims 1 to 6, **characterized in that** it possesses a second output $S_c$ connected to a point of junction between the collector of the first transistor and an end of the first resistor (11), the potential $[2V_{be3} + (R1 + k.R2).i]$ being applied to the other end of the resistor.

8. Amplifier according to one of Claims 1 to 5, **characterized in that** the second arm has a third resistor (13) with a value n.R1, n being smaller than 1, one end of the third resistor being connected to the collector of the second transistor (22) while its other end receives the potential V1 equal to $[2V_{be3} + (R1 + k.R2).i]$, and the first resistor (11) with a value R1 is formed by the sum of the resistance values of a resistor (11a) with a value (1-n).R1 connected to the collector of the first transistor (21), series-connected with a resistor (11b) having a value n.R1, the amplifier having two differential outputs, one $(S_{d1})$ connected to the junction point of these last two resistors and the other $(S_{d2})$ connected to the collector of the second transistor (22).

9. Amplifier according to one of Claims 1 to 5, **characterized in that** the potential $[2V_{be3} + (R1 + k.R2).i]$ is applied to the two arms by the emitters of a fourth transistor (24) and a fifth transistor (25), the bases of which are connected to a base potential $V_b$ equal to $[V_{be4} + 2V_{be3} + (R1 + k.R2).i]$, $V_{be4}$ being the drop in base-emitter voltage of the fourth transistor (24) when the current i flows through it, the amplifier further comprising:

- a fourth resistor (14) connected between the collector of the fourth transistor (24) and a source of voltage (V3),
- a fifth resistor (15) connected between the collector of the fifth transistor (25) and the source of voltage (V3),
- and two differential outputs $(S_{d3})$ and $(S_{d4})$ respectively connected to the collectors of the fourth and fifth transistors (24, 25).

10. Amplifier according to one of Claims 1 to 5, **characterized in that** the potential $[2V_{be3} + (R1 + k.R2).i]$ is applied to the two arms by the emitters of a fourth transistor (24) and a fifth transistor (25) whose bases are connected, the amplifier further comprising:

- a fourth resistor (14) connected between the collector of the fourth transistor (24) and a source of voltage (V4),
- a fifth resistor (15) connected between the collector of the fifth transistor (25) and the source of voltage (V4),
- a sixth transistor (26) whose emitter is connected to the emitter of the fourth transistor (24) and whose collector is connected to the collector of the fifth transistor (25),
- a seventh transistor (27) whose emitter is connected to the emitter of the fifth transistor (25) and whose collector is connected to the collector of the fourth transistor (24), the bases of the sixth and seventh transistors being connected, differential outputs $(S_{d5})$ and $(S_{d6})$ respectively connected to the collectors of the fourth and fifth transistors, the base of the fourth transistor and the base of the sixth transistor receiving alternating differential voltages V01 and V02 having a fixed common mode potential V5 equal to $[V_{be4} + 2V_{be3} + (R1 + k.R2).i]$, $V_{be4}$ being the drop in base-emitter voltage of the fourth transistor (24) when the current i flows through it.

11. Amplifier stage comprising a non-differential input referenced with respect to a reference potential, the input being of a common base type, i.e. made on the emitter of an input transistor, this first transistor converting the input voltage variations into current variations with a non-linear transfer curve that is, in principle, exponential for the bipolar transistors and quadratic for the field-effect transistors, these current variations being themselves copied, with a change in sign, into an arm comprising a second transistor and a third transistor, then converted by the third transistor into voltage variations with a non-linear transfer curve that is reciprocal to the previous one, this curve being in principle a logarithmic or square-root curve, and the voltage at the terminals of the third transistor being used as a feedback applied to the base of the first transistor, the coping of the current being done by causing an imposed current i to flow through the first transistor and by setting up a supply voltage $[V_{be2} + V_{be3} + (R1 + k.R2).i]$ at the terminals of a series-connected assembly comprising a resistor with a value R1 through which the current i flows, an emitter-base junction of the second transistor, a resistor with a value R2 and the third transistor mounted as a diode, $V_{be2}$ and $V_{be3}$ being the voltage drops at the terminals of the base-emitter junctions of the second and third transistors through which a current k.i is assumed to flow, k being a desired ratio of currents.

FIG.1

# FIG.2

## FIG.3

FIG.4